Europäisches Patentamt

European Patent Office

Office européen des brevets

(19)

(11) Numéro de publication : **0 380 397 B1**

(12)

# FASCICULE DE BREVET EUROPEEN

(45) Date de publication du fascicule du brevet :
**08.12.93 Bulletin 93/49**

(51) Int. Cl.⁵ : **H03C 7/02, H04L 27/20**

(21) Numéro de dépôt : **90400171.6**

(22) Date de dépôt : **22.01.90**

(54) **Modulateur équilibré pour signal électromagnétique hyperfréquence de puissance.**

(30) Priorité : **23.01.89 FR 8900752**

(43) Date de publication de la demande :
**01.08.90 Bulletin 90/31**

(45) Mention de la délivrance du brevet :
**08.12.93 Bulletin 93/49**

(84) Etats contractants désignés :
**AT BE CH DE DK ES FR GB GR IT LI LU NL SE**

(56) Documents cités :
EP-A- 0 086 586
IEEE TRANSACTIONS ON MICROWAVE
THEORY AND TECHNIQUES, vol. MTT-35, no.
9, septembre 1987, pages 819-822, IEEE, New
York, US; Y. TARUSAWA et al.: "A new cons-
tant-resistance ASK modulator using dou-
ble-sided MIC"
IEEE TRANSACTIONS ON MICROWAVE
THEORY AND TECHNIQUES, vol. MTT-30, no.
3, mars 1982, pages 227-234, IEEE, New York,
US; H. OGAWA et al.: "Integrated balanced
BPSK and QPSK modulators for the Ka-band"

(56) Documents cités :
PATENT ABSTRACTS OF JAPAN, vol. 7, no. 8
(E-152)[1153], 13 janvier 1983 & JP-A-57-168
507
PATENT ABSTRACTS OF JAPAN, vol. 9, no.
298 (E-361), 26 novembre 1985 & JP-A-60-136
455
PATENT ABSTRACTS OF JAPAN, vol. 11, no. 4
(E-468), 7 janvier 1987 & JP-A-61-179 607

(73) Titulaire : **CENTRE NATIONAL D'ETUDES
SPATIALES**
**2, Place Maurice Quentin**
**F-75001 Paris (FR)**

(72) Inventeur : **Larroque, Joel**
**28, rue des Capucines**
**F-31500 Toulouse (FR)**
Inventeur : **Lapierre, Luc**
**39, rue Bernard Mulé - Appt. 101**
**F-31400 Toulouse (FR)**
Inventeur : **Sombrin, Jacques**
**104, Chemin de Lespinet**
**F-31400 Toulouse (FR)**

(74) Mandataire : **Martin, Jean-Jacques et al**
**Cabinet REGIMBEAU 26, Avenue Kléber**
**F-75116 Paris (FR)**

## Description

La présente invention concerne un modulateur biphase équilibré pour signal électromagnétique hyperfréquence comportant un circuit imprimé double face comprenant :

. une première face comprenant un circuit d'entrée du signal à moduler et un circuit de sortie du signal modulé, lesdits circuits d'entrée et de sortie étant chacun formé par une ligne à ruban,

. une deuxième face comprenant un circuit de modulation de phase, ledit circuit de modulation de phase étant formé par :

- une ligne à fente comprenant une branche d'entrée du signal électrique à moduler couplée audit circuit d'entrée du signal à moduler, une jonction Y prolongeant ladite branche d'entrée et comportant deux branches symétriques, une ligne à fente en forme de boucle reliant lesdites branches symétriques, ladite ligne à fente en forme de boucle étant couplée audit circuit de sortie du signal modulé,

- des premier et deuxième moyens de commutation connectés respectivement en parallèle sur une branche symétrique de la jonction Y,

le couplage entre le circuit d'entrée du signal à moduler et la branche d'entrée de la ligne à fente, d'une part, et entre le circuit de sortie du signal modulé et la ligne à fente en forme de boucle, d'autre part, étant formé par le plan de tension de référence de la ligne à fente, lequel constitue en outre le plan de tension de référence des lignes à ruban formant respectivement lesdits circuit d'entrée du signal à moduler et circuit de sortie du signal modulé, la branche d'entrée de la ligne à fente, la jonction Y, la zone conductrice centrale contenue entre les branches symétriques de la jonction Y et la ligne à fente en forme de boucle, et la ligne à ruban constituant circuit de sortie du signal modulé admettant pour même axe de symétrie, constituant axe de symétrie du circuit de modulation, l'axe de symétrie longitudinal de la ligne à ruban constituant ledit circuit de sortie du signal modulé.

Les modulateurs pour signaux électromagnétiques hyperfréquence sont, d'une façon générale, largement utilisés dans le domaine des télécommunications par satellites. En particulier, ils sont mis en oeuvre, de façon non limitative, dans les satellites géostationnaires pour régénérer, à la réception, les signaux hyperfréquences modulés selon deux états de phase de l'onde porteuse hyperfréquence, ou plus.

Des modulateurs conformes au préambule ont déjà fait l'objet d'études avancées et de publications correspondantes, notamment dans la revue Electronics letters du 12 mars 1987 vol. 23 n° 6.

Pour des signaux électromagnétiques dont la fréquence est supérieure à 1 GHZ, ces modulateurs peuvent être réalisés en technologie planaire par couplage de lignes à ruban et de lignes à fentes, des moyens de commutation, des diodes par exemple, commandés par un signal de commande de modulation permettant de commander la transmission sélective de l'onde électromagnétique hyperfréquence selon deux trajets différents jusqu'à un port de sortie du signal hyperfréquence modulé, l'un des trajets appliquant à l'onde électromagnétique transmise un déphasage de par rapport à l'autre trajet.

De tels modulateurs donnent entière satisfaction, quant à leur fonctionnement, mais de par leur réalisation en technologie planaire, le circuit de modulation étant essentiellement constitué par une ligne à fente en forme de boucle fermée, les deux branches supérieure et inférieure de la boucle constituant les deux trajets précités, la commande des moyens de commutation n'est pas indépendante. Bien que le signal de commande de modulation, consistant, dans le mode de réalisation décrit dans la publication précitée, en une succession d'impulsions rectangulaires d'amplitude positive respectivement négative, permette alternativement la mise en conduction et le blocage de l'un ou l'autre des moyens de commutation, ou réciproquement, les moyens de commutation étant connectés en antiparallèle sur la ligne à fente, l'amplitude de la tension de l'onde électromagnétique à moduler doit être inférieure à la tension de mise en conduction des moyens de commutation, car, bien entendu, l'onde électromagnétique à moduler ne doit, en aucun cas, provoquer de changement d'état de conduction ou de non conduction des moyens de commutation.

En conséquence, les signaux hyperfréquence modulés régénérés par ce type de modulateur ne peuvent excéder une puissance de 1mW environ, compte tenu des caractéristiques diélectriques des circuits imprimés utilisés pour la réalisation de ces types de modulateurs.

Un remède aux inconvénients précités a été apporté, entre autres, par la demande de brevet européen n° 0 086 586 qui décrit un modulateur biphase équilibré pour signal électromagnétique hyperfréquence conforme au préambule et dans lequel la commande des moyens de commutation est totalement séparée. Plus précisément, ce modulateur comporte, en outre, des moyens de commande séparée desdits premier et deuxième moyens de commutation, délivrant auxdits premier et deuxième moyens de commutation un signal de commande de commutation indépendant, et constitués par

. une partition de la zone conductrice centrale en deux zones conductrices adjacentes, constituée par une fente centrale symétrique par rapport à l'axe de symétrie du circuit de modulation, ladite partition constituant un circuit ouvert pour le signal de commande de commutation, délivré auxdits premier et deuxième moyens de commutation et un court-circuit pour le signal hyperfréquence à moduler ou modulé,

. un premier et un deuxième circuit de commande séparée desdits premier et deuxième moyens de commutation, respectivement connectés à l'une et l'autre zone conductrice adjacente et délivrant un signal de commande de commutation à partir d'un même signal de modulation.

Toutefois, ce type de modulation à partition de la zone conductrice centrale, s'il permet la commande séparée des moyens de commutation, présente l'inconvénient de réduire la largeur de bande du circuit du fait de la présence de ladite partition dont l'impédance n'est pas négligeable.

Aussi, le problème technique à résoudre par l'objet de la présente invention est de réaliser un modulateur biphase équilibré pour signal électromagnétique hyperfréquence, conforme au préambule et comportant des moyens de commande séparée, par partition de ladite zone conductrice centrale, des premier et deuxième moyens de commutation, ainsi que l'enseigne de façon générale la demande de brevet européen n° 0 086 586, modulateur qui présenterait une grande largeur de bande, supérieure à celle des modulateurs à commande séparée connus de l'état de la technique.

Une première solution au problème technique posé consiste, selon la revendication 1, en ce que ladite partition étant constituée par une fente centrale symétrique par rapport à l'axe de symétrie dudit circuit de modulation, une pluralité de condensateurs sont régulièrement répartis le long de la fente et assurent la liaison en court-circuit des deux bords de ladite fente à la fréquence du signal à moduler ou modulé. Comme on le verra plus loin en détail, la pluralité de condensateurs est telle que l'impédance de la ligne à fente centrale vis-à-vis de l'onde hyperfréquence est sensiblement nulle, d'où une largeur de bande augmentée.

Une deuxième solution au problème technique posé consiste, selon la revendication 8, en ce que la partition est formée par :

. une première zone électriquement conductrice formant presqu'île vis-à-vis de la zone centrale conductrice et destinée à recevoir l'une des bornes de l'un des moyens de commutation, un intervalle isolant en forme de bande séparant une partie du pourtour de la presqu'île de la zone centrale conductrice,

. une deuxième zone électriquement conductrice formant îlot vis-à-vis de la zone centrale conductrice et destinée à recevoir l'une des bornes de l'autre moyen de commutation, un intervalle isolant en forme de bande séparant le pourtour complet de l'îlot de la zone centrale conductrice.

la première et la deuxième zones électriquement conductrices, formant respectivement presqu'île et îlot vis-à-vis de la zone centrale conductrice, étant sensiblement symétriques par rapport à l'axe de symétrie du circuit modulateur, ladite zone électriquement conductrice formant îlot étant reliée électriquement à la zone centrale conductrice par au moins un condensateur formant court-circuit à la fréquence du signal à moduler ou du signal modulé. Du fait que les lignes définissant les presqu'île et îlot de la partition sont courtes et étroites, le champ électrique n'est pratiquement pas perturbé par leur présence et, en conséquence, la largueur de bande est conservée.

Le modulateur biphase équilibré objet de l'invention trouve application dans tout domaine technique mettant en oeuvre les ondes électromagnétiques hyperfréquences et notamment dans la technique des radars, de l'interrogation IFF, les télécommunications par satellites.

De façon avantageuse, le modulateur biphase équilibré selon la revendication 12 peut être mis en oeuvre dans un modulateur quadriphase équilibré de puissance.

L'invention sera mieux comprise à la lecture de la description et à l'observations des dessins ci-après dans lesquels :

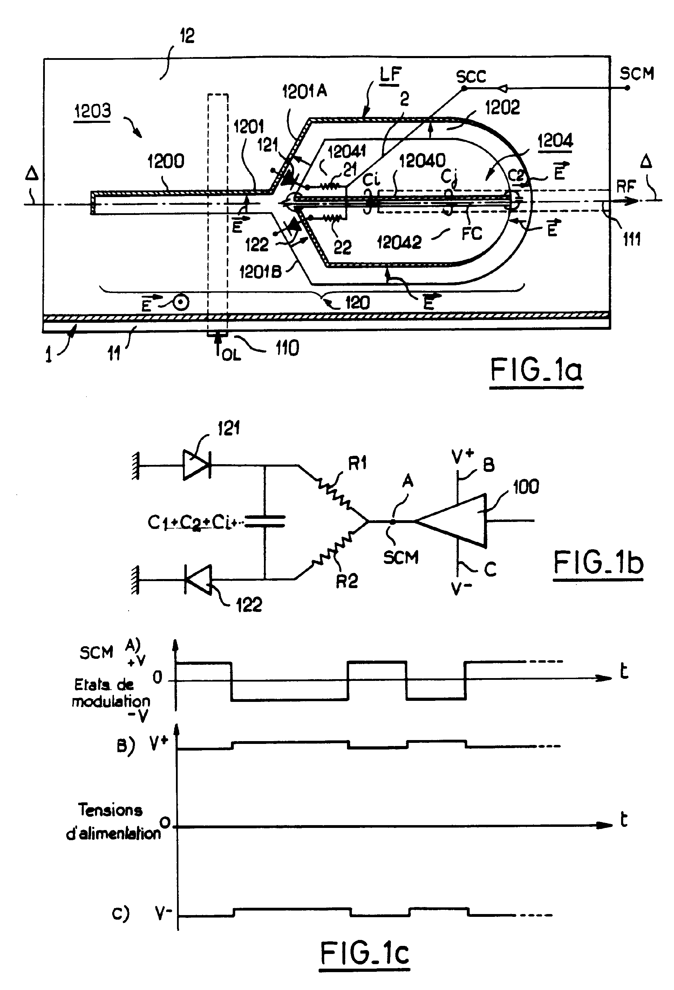

. la figure 1a représente une vue générale d'un modulateur biphase équilibré conforme à l'objet de la présente invention,

. la figure 1b représente un schéma électrique équivalent du modulateur associé au schéma du circuit pilote,

. la figure 1c représente différents chronogrammes aux points de test de la figure 1b,

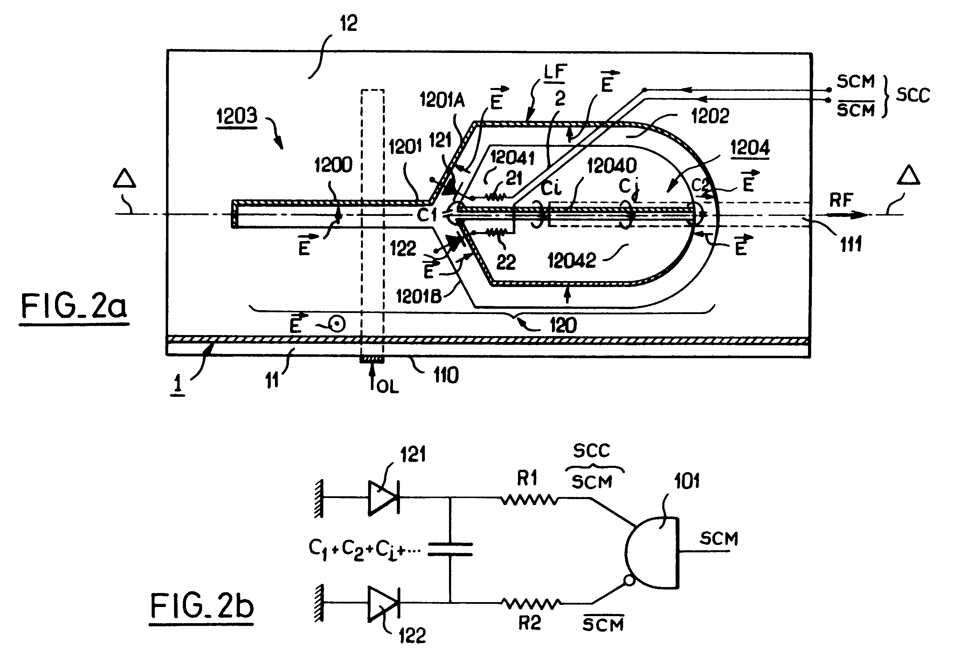

. la figure 2a représente une vue générale d'un modulateur biphase équilibré conforme à l'objet de la présente invention selon une variante de réalisation non limitative,

. la figure 2b représente un schéma électrique équivalent du modulateur associé au schéma du circuit pilote,

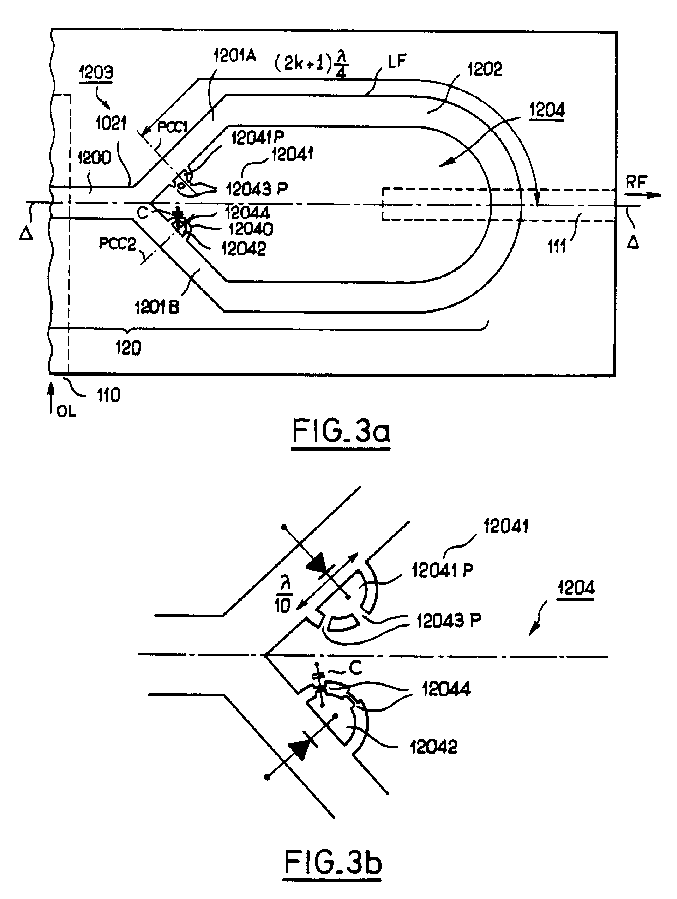

. la figure 3a représente, en plan, un deuxième mode de réalisation d'un circuit de modulation pour un modulateur conforme à l'objet de l'invention,

. la figure 3b représente un détail de réalisation de la figure 3a.

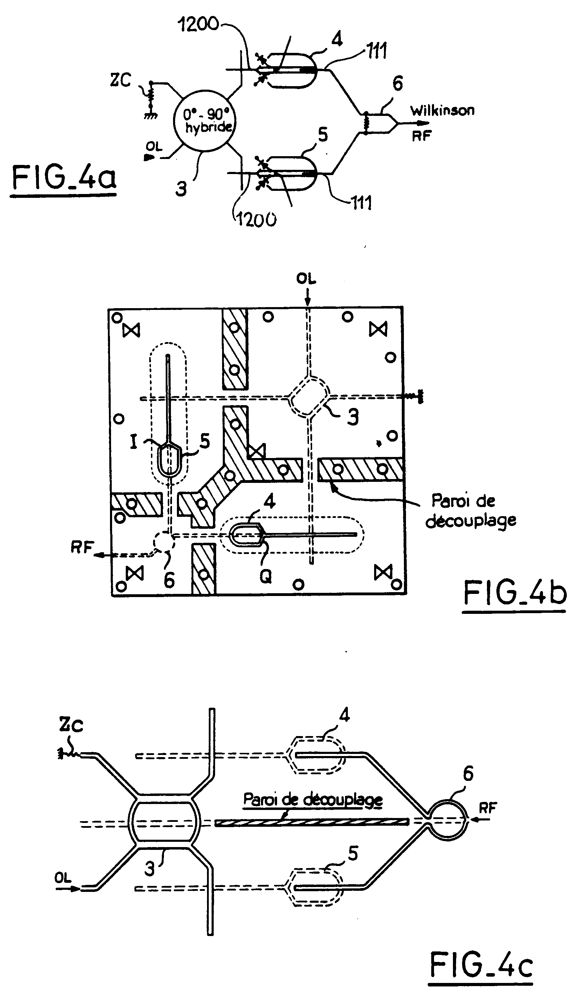

. la figure 4a représente, de manière générale, l'utilisation de modulateurs biphase équilibrés selon l'invention dans un modulateur quadriphase,

. la figure 4b représente une implantation perpendiculaire d'un modulateur quadriphase tel que représenté en figure 4a,

. la figure 4c représente une implantation parallèle d'un modulateur quadriphase tel que représenté en figure 4a.

Le modulateur biphase équilibré objet de l'invention sera tout d'abord décrit en liaison avec la figure 1a.

Selon la figure précitée, le modulateur biphase équilibré objet de l'invention comporte un circuit imprimé 1 double face sur lequel est réalisé le circuit de modulation 120.

La première face 11 du circuit imprimé 1 comprend un circuit d'entrée 110 du signal à moduler. A titre d'exemple non limitatif, le signal à moduler est noté OL en référence, donnée à titre d'exemple, à la régénération de signaux électromagnétiques reçus par des satellites de télécommunication et dans lesquels le signal d'un oscillateur local OL est destiné à reconstituer le signal reçu.

La première face 11 du circuit imprimé 1 comporte également un circuit de sortie 111 du signal modulé, ce signal modulé étant référencé RF et constituant le signal radiofréquence.

Selon une technique classique, les circuits d'entrée 110 et de sortie 111 sont constitués chacun par une ligne à ruban.

A titre d'exemple non limitatif, le circuit imprimé 1 peut être constitué par un circuit imprimé, dont le matériau diélectrique est constitué par de l'alumine, ce matériau présentant de meilleure qualité de rigidité mécanique que les matériaux de type diélectrique classique et possédant une constante de permittivité électrique relative élevée, $\varepsilon r = 10$.

Bien entendu, sur la figure 1a, on a représenté les lignes à ruban 110 et 111 en traits pointillés, car ces lignes sont disposées sur la face 11 opposée à la face représentée par le plan du dessin.

Le circuit imprimé 1 comporte également une deuxième face 12 comprenant un circuit de modulation de phase 120. Le circuit de modulation de phase est formé par une ligne à fente LF comprenant une branche d'entrée 1200 permettant d'assurer l'entrée du signal électrique à moduler OL dans le circuit modulateur 120. La branche d'entrée 1200 est couplée au circuit d'entrée 110 du signal à moduler OL. Une jonction Y 1201 prolonge la branche d'entrée 1200 et comporte deux branches symétriques 1201A et 1201B. Une ligne à fente en forme de boucle ouverte ou de U renversé est notée 1202 et relie les branches symétriques de la jonction Y pour former un circuit fermé comportant la première branche 1201A, la boucle ouverte 1202 et la deuxième branche symétrique 1201B.

Bien entendu, la ligne à fente en forme de boucle 1202 est couplée au circuit 111 de sortie du signal modulé RF.

Le couplage, entre la branche d'entrée 1200 de la ligne à fente et la ligne à ruban 110 constituant ligne d'entrée du signal à moduler OL, d'une part, et entre la ligne en forme de boucle ouverte 1202 et le circuit de sortie 111 du signal radiofréquence RF modulé, d'autre part, est optimal lorsque la ligne microruban considérée présente un court-circuit au niveau de la transition entre les deux lignes et lorsque la ligne à fente LF présente un circuit ouvert.

Les lignes à ruban constituant les circuit d'entrée 110 et circuit de sortie 111 sont de préférence constituées par des lignes à microruban d'impédances caractéristiques 50 ohms.

En outre, ainsi qu'on l'a représenté également en figure 1a, des premiers 121 et deuxièmes 122 moyens de commutation sont connectés respectivement en parallèle sur une branche symétrique 1201A et 1201B de la jonction Y précitée.

Bien entendu, la position optimale des moyens de commutation 121 et 122 est déterminée sur chaque branche symétrique 1201A, 1201B de la jonction Y de façon à ramener un court-circuit dans le plan anti-principal de la jonction Y précitée.

Ainsi qu'on l'a, en outre, représenté en figure 1a, le modulateur biphase équilibré objet de l'invention comporte également des moyens 2 de commande séparée des premiers 121 et deuxièmes 122 moyens de commutation. Les moyens 2 de commande séparée délivrent aux premiers et deuxièmes moyens de commutation 121, 122 un signal de commande de commutation indépendant.

Ainsi qu'on l'a en outre représenté en figure 1a, le couplage, entre le circuit d'entrée 110 du signal à moduler OL et la branche d'entrée 1200 de la ligne à fente, d'une part, et entre le circuit de sortie 111 du signal modulé RF et la ligne à fente en forme de boucle 1202, est formé bien entendu par le plan de tension de référence ou plan de masse 1203 de la ligne à fente LF, lequel constitue en outre le plan de tension de référence des lignes à ruban formant respectivement le circuit d'entrée 110 du signal à moduler et le circuit 111 du signal modulé.

Afin d'obtenir un modulateur équilibré particulièrement performant, la branche d'entrée 1200 de la ligne à fente LF, la jonction Y 1201, la zone conductrice centrale 1204 contenue entre les branches symétriques 1201A et 1201B de la jonction Y et la ligne à fente en forme de boucle 1202, et la ligne à ruban constituant un circuit de sortie 111 du signal modulé RF admettent, pour même axe de symétrie, constituant axe de symétrie du circuit de modulation 120, l'axe de symétrie $\Delta$ longitudinal de la ligne à ruban constituant le circuit de sortie 111 du signal modulé RF.

Bien entendu, les premiers et deuxièmes moyens de commutation 121, 122 et, en particulier, leur plan équivalent de court-circuit ayant été disposés et positionnés convenablement, ainsi que déterminé précédemment par rapport au plan anti-principal de la jonction Y, la longueur correspondante de la demi-boucle, formée par une partie de chaque branche symétrique 1201A, 1201B et par la moitié supérieure ou inférieure de la ligne à fente en forme de boucle 1202, est choisie égale à un multiple impair de quarts de longueur d'onde de la longueur d'onde du signal électromagnétique hyperfréquence se propageant dans la ligne à fente LF, de manière à ramener un circuit ouvert au niveau de la transition de sortie par inversion de l'impédance du court circuit obtenu alternativement au rythme de la modulation par l'un ou l'autre des deux moyens de commutation 121 ou 122.

Le fonctionnement du modulateur, tel que représenté en figure 1a, est le suivant :

Le signal de commande de commutation SCC est délivré par exemple sous forme d'un signal alternatif de commande de modulation SCM, lequel présente par exemple une suite d'alternances de polarités positives et négatives. Ce signal SCC est appliqué par les moyens 2 de commande séparée aux premiers et aux deuxièmes moyens de commutation 121, 122.

Un changement d'état du signal de commande de commutation, +V, -V, entraîne un changement d'état des diodes, celles-ci étant placées respectivement en court-circuit ou en circuit ouvert. Le signal hyperfréquence OL à moduler passe dans la branche de la jonction Y dont la diode est en circuit ouvert. Ainsi, le champ électrique créé au niveau de la sortie radiofréquence RF présente deux états de phase possibles séparés de 180° suivant le chemin parcouru. La symétrie géométrique du montage permet d'obtenir une très bonne symétrie de phase.

Afin d'assurer la transmission de signaux hyperfréquences de puissance convenablement modulés en phase en l'absence de tout fonctionnement intempestif des diodes 121 et 122, c'est-à-dire pour éviter que les diodes ne soient contrôlées par le signal hyperfréquence, ainsi qu'on l'a représenté notamment en figure 1a, les moyens de commande 2 comprennent une partition 12040 de la zone conductrice centrale 1204 en deux zones conductrices adjacentes 12041, 12042.

Bien entendu, la partition 12040 constitue un circuit ouvert pour le signal de commande de commutation SCC délivré aux premiers et deuxièmes moyens de commutation ou diodes 121, 122 et un court-circuit pour le signal hyperfréquence à moduler OL ou modulé RF.

En outre, un premier 21 et un deuxième 22 circuit de commande séparée des diodes 121 et 122 permettent, à partir du signal de commande de commutation SCC, le premier et le deuxième circuit 21, 22, étant respectivement connectés à l'une et l'autre zones conductrictes adjacentes 12041, 12042, de délivrer un signal de commande de commutation SCC à partir du même signal de modulation SCM.

Chaque diode, constituant les premiers et deuxièmes moyens de commutation 121, 122, est montée sur chacune des branches 1201A, 1201B de la jonction Y entre le plan de tension de référence et l'une des zones conductrices adjacentes, de façon telle que les deux diodes, étant sur la ligne à fente formée par les deux branches symétriques 1201A, 1201B de la jonction Y, soient montées en anti-parallèle.

On comprendra que le montage anti-parallèle précité des deux diodes 121 et 122, pour une onde hyperfréquence de polarisation donnée se propageant dans la branche d'entrée 1200 de la ligne à fente LF, permet d'obtenir sur chaque branche symétrique de la jonction Y une direction de conduction de chacune des diodes 121, 122, c'est-à-dire direction anode-cathode simultanément parallèle ou anti-parallèle à la direction correspondante du champ électrique de l'onde électromagnétique se propageant sur la branche symétrique correspondante 1201A ou 1201B de la jonction Y précitée.

Dans le mode de réalisation de la figure 1a, le signal de commande de commutation SCC est formé par un signal alternatif dont les alternances sont successivement positives et négatives d'amplitude +V, -V par exemple, par rapport à la tension de référence ou tension de masse du modulateur.

Un schéma électrique équivalent au modulateur, représenté en figure 1a avec le schéma du circuit pilote associé, est donné en figure 1b. Bien entendu, afin d'assurer, pour la partition 12040, une impédance équivalente à un court-circuit à la fréquence de l'onde électromagnétique hyperfréquence, une pluralité de condensateurs Ci et, plus particulièrement, CI à Cn est connectée de façon à relier les deux zones conductrices adjacentes 12041, 12042. Bien entendu, chaque condensateur Ci est choisi de façon à présenter à la fréquence considérée de l'onde hyperfréquence une impédance sensiblement nulle.

Le schéma électrique équivalent de la figure Ib est représenté, les deux diodes 121 et 122 étant connectées en anti-parallèle et reliées par la capacité équivalente à l'ensemble des capacités Ci. Les circuits de commande séparée 21 et 22 peuvent alors être constitués par des résistances R1 et R2, lesquelles sont alimentées à partir d'un amplificateur 100, lequel, à partir de tensions d'alimentations +V et -V, délivre sur déclenchement par le signal SCM le signal SCC égal à +V ou -V à la borne commune des résistances R1 et R2.

Ainsi qu'on pourra le constater, et tel qu'il a été représenté en figure 1b, les diodes 121 et 122 sont montées en opposition vis-à-vis du signal de commande de modulation SCC. La présence des résistances R1 et R2 permet de limiter le courant en direct dans les diodes. On indiquera également que la somme des capacités Ci doit être suffisamment faible afin, compte tenu de la présence des résistances R1 et R2, de ne pas provoquer d'effets néfastes de filtrage sur le signal modulant SCC tout en conservant une valeur suffisamment importante pour cette capacité résultante, afin que celle-ci soit assimilable à un court-circuit vis-à-vis du signal hyperfréquence.

Il est alors possible, conformément au mode de réalisation de la figure 1a, d'appliquer une forte tension en inverse sur les diodes 121 et 122, cette tension n'est pas limitée par la tension de conduction des diodes en direct puisque chaque diode est maintenant séparée du point de vue de la commande de commutation.

Le circuit précédemment décrit est parfaitement symétrique et la symétrie doit être parfaitement conservée en ce qui concerne la création des tensions +V et -V de commande de commutation. Celles-ci peuvent être délivrées par deux alimentations symétriques, l'une positive, l'autre négative par rapport à la tension de référence ou masse du modulateur.

Sur la figure 1c, on a représenté différents signaux aux points de test A, B, C de la figure 1b. Le signal +V, -V étant appliqué au point A de la figure 1b, ce signal constitue le signal de commande de modulation SCM des figures 1b et 1a pour lequel les états de modulation des diodes 121 et 122 sont obtenus.

Les diodes étant montées en opposition vis-à-vis du signal de modulation SCM ou de chaque signal de commande de commutation SCC, il existe cependant, suivant l'état de la modulation, soit un appel de courant sur l'alimentation positive, soit un appel de courant sur l'alimentation négative.

Dans ce cas, ainsi que représenté en figure 1c, les tensions positives et négatives délivrées par les alimentations symétriques précitées sont alors susceptibles de subir une modulation parasite par le signal modulant, la valeur vrai de l'amplitude de tension délivrée par chaque alimentation symétrique variant légèrement en raison même de la modulation de phase ou de la commutation des diodes.

Afin de remédier au problème de la modulation parasite des alimentations symétriques permettant d'engendrer les signaux de commutation SCC relatifs aux deux diodes 121 et 122 de la figure 1a, il peut être avantageux, en fonction des applications considérées, de réaliser le modulateur objet de l'invention tel que représenté en figure 2a et dont la description sera donnée ci-après.

Sur la figure précitée, les mêmes éléments sont désignés par les mêmes références que dans le cas de la figure 1a.

Cependant, et bien que la partition 12040 soit aussi ménagée de façon à subdiviser la zone conductrice centrale 1204 en deux zones adjacentes 12041, 12042, chaque diode 121, 122, constituant les premiers et deuxièmes moyens de commutation, ainsi que représenté en figure 2a, est montée sur chacune des branches 1201A, 1201B de la jonction Y entre le plan de tension de référence 1203 et l'une des zones conductrices adjacentes 12041 ou 12042, de façon que les deux diodes soient, sur la ligne à fente formée par les deux branches symétriques 1201A et 1201B de la jonction Y, montées en parallèle.

Dans ce cas, et contrairement au mode de réalisation de la figure 1a, pour une direction de polarisation déterminée de l'onde électromagnétique hyperfréquence se propageant sur la branche d'entrée 1200 de la ligne à fente LF, les deux diodes précitées 121 et 122 présentent une direction de conduction, c'est-à-dire une direction anode-cathode, opposée par rapport au champ électrique auquel ces diodes sont soumises sur la branche symétrique 1201A ou 1201B de la jonction Y correspondante.

Dans ce cas, la direction de conduction de l'une des diodes 121 et 122 est la même que celle de la direction du champ électrique de l'onde électromagnétique se propageant sur la branche symétrique 1201A ou 1201B de la jonction Y correspondante ou opposée à celle-ci réciproquement. Dans une telle configuration, les diodes 121 et 122 sont montées dans le même sens vis-a-vis du signal de commande de commutation SCC ou du signal de commande de moduiation SCM et la commande des diodes 121 et 122 peut alors être effectuée séparément en complémentaire, les tensions d'alimentations n'ayant plus à présenter une polarité symétrique. Dans ce cas, le signal de commande de modulation SCM alimente par exemple le premier circuit de commande 21, alors que le deuxième circuit de commande 22 est commandé séparément par le signal de commande de modulation complémenté $\overline{SCM}$.

Ainsi qu'on l'a représenté en figure 2b, le circuit électrique équivalent correspond à celui de deux diodes 121 et 122 connectées en parallèle et reliées par les capacités ou condensateurs équivalents égales à la somme des capacités Ci. Deux résistances R1 et R2 peuvent alors être reliées directement à un circuit logique 101, lequel, à partir d'un signal de commande de modulation SCM, permet de délivrer, d'une part, ce même signal SCM à l'une des diodes, la diode 121 par exemple, et le signal de commande de modulation complémenté $\overline{SCM}$ à la diode 122.

Les résistances R1 et R2 jouant le même rôle que dans le cas de la figure 1a, les alimentations destinées à engendrer les tensions de commande SCM et $\overline{SCM}$ ne sont pas soumises à la moduiation parasite précédemment décrite dans le cas de la figure 1a et il est, en outre, possible d'appliquer une forte tension en inverse sur les diodes 121 et 122, tout en ayant une bonne protection en courant lorsque les diodes sont polarisées en direct. Bien entendu, dans ce cas également, une forte puissance de signal hyperfréquence peut alors transiter par le modulateur, tel que décrit en figure 2a.

Ainsi qu'on l'aura noté, relativement aux figures 1a et 2a, la partition 12040 est sensiblement symétrique par rapport à l'axe de symétrie Δ du circuit de modulation 120. Ceci, bien entendu, permet de conserver le caractère de symétrie du montage et du modulateur et, en conséquence, le caractère équilibré de la modulation de phase obtenue au niveau de l'onde hyperfréquence modulée.

La partition 12040 est constituée selon un mode de réalisation non limitatif par une fente centrale FC symétrique par rapport à l'axe de symétrie Δ du circuit de modulation et par une pluralité de condensateurs Ci régulièrement répartis le long de la fente FC précitée. Ces condensateurs assurent la liaison en court-circuit des deux bords de la fente FC à la fréquence du signal à moduler ou du signal modulé. Bien entendu, ces condensateurs peuvent être répartis uniformément et présenter des valeurs adaptées en fonction de leur position des condensateurs de plus forte valeur étant interconnectés en extrémité de la fente centrale FC.

De préférence, la fente centrale FC présente une largeur ou dimension dans une direction perpendiculaire à l'axe longitudinal Δ du circuit de modulation 120, largeur $\ell \leqq \frac{\lambda}{20}$ où λ représente la longueur d'onde du signal à moduler OL ou du signal modulé RF.

Bien entendu, d'autres modes de réalisation du modulateur objet de l'invention peuvent être envisagés sans sortir du cadre de l'objet de la présente invention. En particulier, des réalisations, dans lesquelles la partition 12040 est réalisée de façon que celle-ci présente une quasi-symétrie par rapport à l'axe longitudinal Δ du circuit de modulation 120, peuvent être envisagées, la partition précitée étant alors désignée comme sensiblement symétrique.

Un mode de réalisation non limitatif d'une partition sensiblement symétrique sera donnée en liaison avec les figures 3a et 3b.

Dans le mode de réalisation des figures précitées, la partition 12040 est formée par une première zone électriquement conductrice 12041P formant presqu'île vis-à-vis de la zone centrale conductrice 1204, la fente centrale FC étant supprimée. La première zone électriquement conductrice 12041P formant presqu'île est destinée à recevoir l'une des bornes de l'une des diodes, la diode 121 par exemple.

Une deuxième zone électriquement conductrice 12042 forme îlot vis-à-vis de la zone centrale conductrice 1204 et est destinée à recevoir l'une des bornes de l'autre diode, la diode 122 par exemple.

Bien entendu la première et la deuxième zone électriquement conductrice formant respectivement presqu'île 12041P et îlot 12042 vis-à-vis de la zone centrale 1204 conductrice sont sensiblement symétriques par rapport à l'axe Δ de symétrie du circuit modulateur 120.

Dans ce cas, la zone électriquement conductrice 12042 formant îlot est reliée électriquement à la zone centrale conductrice 1204 par au moins un condensateur C, tel que représenté en figure 3a formant court-circuit à la fréquence du signal à moduler ou du signal modulé.

Bien entendu, afin d'assurer un maximum de symétrie pour le mode de réalisation des figures 3a et 3b, de préférence, la plus grande dimension de définition des zones électriquement conductrices formant presqu'île 12041P ou îlot 12042, est choisie inférieure ou égale à $\frac{\lambda}{10}$ où λ représente la longueur d'onde du signal à moduler ou du signal modulé.

Ainsi qu'on l'a représenté de façon plus détaillée en figure 3b, la zone électriquement conductrice formant presqu'île 12041P est reliée par exemple à la zone électriquement conductrice centrale 1204 par au moins un isthme 12043P.

De la même manière, l'intervalle, séparant la zone électriquement conductrice formant îlot 12042 de la zone électriquement conductrice centrale 1204, est muni d'au moins un isthme tronqué 12044 dans lequel l'intervalle est plus étroit que le long du reste du pourtour de l'îlot. Les isthmes tronqués et les isthmes sont disposés symétriquement par rapport à l'axe de symétrie Δ du circuit modulateur 120. On comprendra, bien entendu, que la seule différence de symétrie entre les zones électriquement conductrices formant presqu'île 12041 P ou îlot 12042 réside en fait dans la présence de la troncature de chaque isthme tronqué, ces troncatures pouvant être rendues aussi faibles que possible grâce à l'utilisation de la technique des circuits imprimés.

L'utilisation des modulateurs précédemment décrits n'est pas limitée à la modulation biphase. Une utilisation des modulateurs biphase équilibrés précédemment décrits pour la réalisation de modulateurs quadriphase, sera décrite en liaison avec les figures 4a, 4b, 4c.

De manière générale, la réalisation de modulation quadriphase de type parallèle à partir de deux modulateurs biphase, tel que décrit précédemment, peut être obtenue à partir d'un coupleur d'hybride 0°-90° et d'un additionneur de puissance.

Sur la figure 4a, le coupleur hybride 0°-90° est noté 3 et deux modulateurs biphase équilibrés, tel que précédemment décrit, sont utilisés et notés 4 et 5 pour réaliser une modulation biphase à partir des deux sorties symétriques du coupleur hybride 3. Le choix des circuits réalisés en ligne microbande par exemple, sur la face 1 du circuit imprimé, du coupleur hybride 3, permet d'avoir une connexion directe avec les entrées et les sorties des modulateurs biphase 4 et 5. L'ensemble peut ainsi être intégré sur le même circuit. L'additionneur de puissance 6 peut être par exemple un additionneur de type Wilkinson.

Dans tous les cas, le signal à moduler OL est introduit sur l'une des entrées du circuit coupleur hybride 3, l'entrée symétrique étant chargée par une impédance égale à l'impédance caractéristique ZC. Les deux sorties symétriques du coupleur hybride 3 sont alors couplées à la branche d'entrée de la ligne à fente 1200 des modulateurs biphase 4 et 5 représentés en figure 4a. Les lignes du circuit de sortie 111 de chaque modulateur biphase équilibré 4 et 5 sont alors reliées directement au port d'entrée de l'additionneur de puissance de Wilkinson 6.

Bien entendu, l'implantation des différents éléments du modulateur quadriphase correspond à une implantation perpendiculaire, par exemple, l'axe longitudinal Δdes modulateurs ou des circuits modulateur ou des modulateurs 4 et 5 étant perpendiculaire, ainsi que représenté en figure 4b, ou au contraire parallèle, ainsi que représenté en figure 4c.

On notera que dans les deux cas précités et représentés en figures 4b et 4c, les résultats sont sensiblement identiques en ce qui concerne les pertes d'insertion de l'ordre de 5,5 dB et la modulation d'amplitude résiduelle de plus ou moins 0,1 B, chaque état de phase étant obtenu à plus ou moins 1°.

L'implantation perpendiculaire offre comme principal avantage d'éliminer des fréquences de résonance de boîtier qui se trouvent au voisinage du spectre du signal de sortie RF.

On a ainsi décrit un modulateur biphase équilibré particulièrement performant, lequel permet de régénérer un signal hyperfréquence reçu par un satellite de télécommunication par exemple. Ces dispositifs sont particulièrement avantageux dans le cadre des liaisons numériques à fréquence de rythme élevé, via un satellite de relais de données ou de télécommunications. En outre, l'utilisation de ces modulateurs biphase n'est pas limitée à la seule modulation biphase, mais peut être avantageusement envisagée pour la modulation quadriphase, moyennant les adaptations précédemment décrites.

## Revendications

1. Modulateur biphase équilibré pour signal électromagnétique hyperfréquence comportant :

   a) un circuit imprimé (1) double face comprenant :

   . une première face (11) comprenant un circuit d'entrée (110) du signal à moduler (OL) et un circuit de sortie (111) du signal modulé (RF), lesdits circuits d'entrée (110) et de sortie (111) étant chacun formé par une ligne à ruban,

   . une deuxième face (12) comprenant un circuit de modulation de phase (120), ledit circuit de modulation de phase étant formé par :

   - une ligne à fente (LF) comprenant une branche d'entrée (1200) du signal électrique à moduler (OL) couplée audit circuit d'entrée (110) du signal à moduler, une jonction Y (1201) prolongeant ladite branche d'entrée et comportant deux branches symétriques (1201A, 1201B), une ligne à fente en forme de boucle (1202) reliant lesdites branches symétriques, ladite ligne à fente en forme de boucle (1202) étant couplée audit circuit (111) de sortie du signal modulé (RF),

   - des premier (121) et deuxième (122) moyens de commutation connectés respectivement en parallèle sur une branche symétrique (1201A, 1201B) de la jonction Y,

   le couplage entre le circuit d'entrée (110) du signal à moduler (OL) et la branche d'entrée (1200) de la ligne à fente, d'une part, et entre le circuit de sortie (111) du signal modulé (RF) et la ligne à fente en forme de boucle (1202), d'autre part, étant formé par le plan de tension de référence (1203) de la ligne à fente (LF), lequel constitue en outre le plan de tension de référence des lignes à ruban formant respectivement lesdits circuit d'entrée (110) du signal à moduler et circuit de sortie (111) du signal module, la branche d'entrée (1200) de la ligne à fente, la jonction Y (1201), la zone conductrice centrale (1204) contenue entre les branches symétriques (1201A, 1201B) de la jonction Y et la ligne à fente en forme de boucle (1202), et la ligne à ruban constituant circuit de sortie (111) du signal modulé admettant pour même axe de symétrie, constituant axe de symétrie du circuit de modulation (120), l'axe de symétrie longitudinal (Δ) de la ligne à ruban constituant ledit circuit de sortie (111) du signal modulé,

   ledit modulateur comportant en outre
   b) des moyens (2) de commande séparée desdits premier (121) et deuxième (122) moyens de commutation, délivrant auxdits premier et deuxième moyens de commutation un signal de commande de commutation indépendant, et constitués par

   . une partition (12040) de la zone conductrice centrale (1204) en deux zones conductrices adjacentes (12041, 12042), ladite partition (12040) constituant un circuit ouvert pour le signal de commande de commutation (SCC) délivré auxdits premier et deuxième moyens de commutation (121, 122) et un court-circuit pour le signal hyperfréquence à moduler (OL) ou modulé (RF),

   . un premier (21) et un deuxième (22) circuit de commande séparée desdits premier et deuxième moyens de commutation (121, 122), respectivement connectés à l'une et l'autre zone conductrice adjacente (12041, 12042) et délivrant un signal de commande de commutation (SCC) à partir d'un même signal de modulation (SCM),

caractérisé en ce que, ladite partition étant constituée par une fente centrale (FC) symétrique par rapport à l'axe de symétrie (Δ) dudit circuit de modulation, une pluralité de condensateurs (Ci) sont régulièrement répartis le long de la fente et assurent la liaison en court-circuit des deux bords de ladite fente à la fréquence du signal à moduler ou modulé.

2. Modulateur selon la revendication 1, caractérisé en ce que lesdits premier et deuxième moyens de commutation (121, 122) sont constitués chacun par une diode.

3. Modulateur selon la revendication 2, caractérisé en ce que chaque diode constituant les premier (121) et deuxième (122) moyens de commutation est montée sur chacune des branches (1201A, 1201B) de la jonction Y entre le plan de tension de référence et l'une des zones conductrices adjacentes, les deux diodes étant sur la ligne à fente formée par les deux branches symétriques (1201A, 1201B) de la jonction Y montées en anti-parallèle.

4. Modulateur selon la revendication 3, caractérisé en ce que le signal de commande de commutation (SCC) est formé par un signal alternatif dont les alternances sont successivement positives et négatives (+V, -V) par rapport à la tension de référence du modulateur.

5. Modulateur selon la revendication 2, caractérisé en ce que chaque diode (121, 122), constituant les premier et deuxième moyens de commutation, est montée sur chacune des branches (1201A, 1201B) de la jonction Y entre le plan de tension de référence (1203) et l'une des zones conductrices adjacentes (12041, 12042), les deux diodes étant sur la ligne à fente formée par les deux branches symétriques (1201A, 1201B) de la jonction Y montées en parallèle.

6. Modulateur selon la revendication 5, caractérisé en ce que le signal de commande de modulation de phase (SCM) est formé par un signal alternatif, les signaux de commande de commutation (SCC) de l'une et l'autre diodes étant complémentés (SCM, $\overline{\text{SCM}}$).

7. Modulateur selon l'une des revendications 1 à 6, caractérisé en ce que ladite fente centrale (FC) présente une largeur $\ell \leqq \dfrac{\lambda}{20}$ où $\lambda$ représente la longueur d'onde du signal à moduler (OL) ou module (RF).

8. Modulateur biphase équilibré pour signal électromagnétique hyperfréquence comportant :

a) un circuit imprimé (1) double face comprenant :

. une première face (11) comprenant un circuit d'entrée (110) du signal à moduler (OL) et un circuit de sortie (111) du signal modulé (RF), lesdits circuits d'entrée (110) et de sortie (111) étant chacun formé par une ligne à ruban,

. une deuxième face (12) comprenant un circuit de modulation de phase (120), ledit circuit de modulation de phase étant formé par :

- une ligne à fente (LF) comprenant une branche d'entrée (1200) du signal électrique à moduler (OL) couplée audit circuit d'entrée (110) du signal à moduler, une jonction Y (1201) prolongeant ladite branche d'entrée et comportant deux branches symétriques (1201A, 1201B), une ligne à fente en forme de boucle (1202) reliant lesdites branches symétriques, ladite ligne à fente en forme de boucle (1202) étant couplée audit circuit (111) de sortie du signal modulé (RF),

- des premier (121) et deuxième (122) moyens de commutation connectés respectivement en parallèle sur une branche symétrique (1201A, 1201B) de la jonction Y,

le couplage entre le circuit d'entrée (110) du signal à moduler (OL) et la branche d'entrée (1200) de la ligne à fente, d'une part, et entre le circuit de sortie (111) du signal modulé (RF) et la ligne à fente en forme de boucle (1202), d'autre part, étant formé par le plan de tension de référence (1203) de la ligne à fente (LF), lequel constitue en outre le plan de tension de référence des lignes à ruban formant respectivement lesdits circuit d'entrée (110) du signal à moduler et circuit de sortie (111) du signal modulé, la branche d'entrée (1200) de la ligne à fente, la jonction Y (1201), la zone conductrice centrale (1204) contenue entre les branches symétriques (1201A, 1201B) de la jonction Y et la ligne à fente en forme de boucle (1202), et la ligne à ruban constituant circuit de sortie (111) du signal modulé admettant pour même axe de symétrie, constituant axe de symétrie du circuit de modulation (120),

l'axe de symétrie longitudinal (Δ) de la ligne à ruban constituant ledit circuit de sortie (111) du signal modulé,

ledit modulateur comportant en outre
b) des moyens (2) de commande séparée desdits premier (121) et deuxième (122) moyens de commutation, délivrant auxdits premier et deuxième moyens de commutation un signal de commande de commutation indépendant, et constitués par

. une partition (12040) de la zone conductrice centrale (1204) en deux zones conductrices adjacentes (12041, 12042), ladite partition (12540) constituant un circuit ouvert pour le signal de commande de commutation (SCC) délivré auxdits premier et deuxième moyens de commutation (121, 122) et un court-circuit pour le signal hyperfréquence à moduler (OL) ou modulé (RF),

. un premier (21) et un deuxième (22) circuit de commande séparée desdits premier et deuxième moyens de commutation (121, 122), respectivement connectés à l'une et l'autre zone conductrice adjacente (12041, 12042) et délivrant un signal de commande de commutation (SCC) à partir d'un même signal de modulation (SCM),

caractérisé en ce que ladite partition (12040) est formée par:

. une première zone électriquement conductrice (12041P) formant presqu'île vis-à-vis de la zone centrale conductrice (1204) et destinée à recevoir l'une des bornes de l'un des moyens de commutation, un intervalle isolant en forme de bande séparant une partie du pourtour de la presqu'île de la zone centrale conductrice,

. une deuxième zone électriquement conductrice (12042) formant îlot vis-à-vis de la zone centrale conductrice et destinée à recevoir l'une des bornes de l'autre moyen de commutation, un intervalle isolant en forme de bande séparant le pourtour complet de l'îlot de la zone centrale conductrice

la première et la deuxième zones électriquement conductrices, formant respectivement presqu'île (12041P) et îlot (12042) vis-à-vis de la zone centrale conductrice. étant sensiblement symétriques par rapport à l'axe (Δ) de symétrie du circuit modulateur, ladite zone électriquement conductrice (12042) formant îlot étant reliée électriquement à la zone centrale conductrice (1204) par au moins un condensateur (C) formant court-circuit à la fréquence du signal à moduler ou du signal modulé.

9. Modulateur selon la revendication 8, caractérisé en ce que la plus grande dimension de définition des zones électriquement conductrices (12041P, 12042) formant presqu'île ou îlot est inférieure ou egale à $\frac{\lambda}{10}$ où λ représente la longueur d'onde du signal à moduler ou du signal modulé.

10. Modulateur selon la revendication 9, caractérisé en ce que ladite zone électriquement conductrice, formant presqu'île (12041P), est reliée à ladite zone électriquement conductrice centrale (1204) par au moins un isthme (12043P), l'intervalle séparant la zone électriquement conductrice formant îlot de la zone électriquement conductrice centrale étant muni d'au moins un isthme tronqué (12044), dans lequel l'intervalle est plus étroit que le long du reste du pourtour de l'îlot, les isthmes tronqués et les isthmes étant disposés symétriquement par rapport à l'axe de symétrie (Δ) du circuit modulateur.

11. Modulateur selon l'une des revendications 8 à 10, caractérisé en ce que lesdits premier et deuxième moyens de commutation (121, 122) sont constitués chacun par une diode.

12. Modulateur équilibré pour signal hyperfréquence, caractérisé en ce que ledit modulateur comporte un circuit coupleur hybride (3) un premier et un deuxième modulateurs biphase équilibrés (4, 5) selon l'une des revendications précédentes et un circuit additionneur de puissance (6) de type Wilkinson, le circuit coupleur hybride (3) recevant sur l'une de ses entrées le signal à moduler (OL), alors que l'entrée symétrique du coupleur hybride (3) est chargée par une impédance, égale à l'impédance caractéristique (ZC), et la première et deuxième sorties symétriques de ce coupleur (3) sont couplées respectivement, à la branche d'entrée de la ligne à fente (1200) du premier et du deuxième modulateurs biphase (4,5), dont les lignes du circuit de sortie (111) sont reliées au port d'entrée de l'additionneur de puissance de type Wilkinson (6).

## Patentansprüche

1. Zweiphasiger Gegentakt-Modulator für ein elektromagnetisches Mikrowellensignal, umfassend:
a) eine zweiseitige, gedruckte Schaltung (1) umfassend:
. eine erste Seite (11), die einen Eingangskreis (110) des zu modulierenden Signals (OL) und einen Ausgangskreis (111) des modulierten Signals (RF) umfaßt, wobei der genannte Eingangskreis (110) und der genannte Ausgangskreis (111) jeweils durch einen Bandleiter gebildet sind,

. eine zweite Seite (12), die einen Phasenmodulationskreis (129) umfaßt, wobei der Phasenmodulationskreis gebildet ist durch:

- eine Leitung mit einem Spalt (LF), die einen Eingangszweig (1200) für das zu modulierende, elektrische Signal (OL), der mit dem genannten Eingangskreis (110) des zu modulierenden Signals gekoppelt ist, eine Y Verbindung (1201), die den genannten Eingangszweig verlängert und zwei symmetrische Zweige (1201A, 1201B) umfaßt, eine Leitung mit einem Spalt in der Form einer Schleife (1202), die die genannten symmetrischen Zweige verbindet, wobei die genannte Leitung mit einem Spalt in der Form der Schleife (1202) mit dem genannten Ausgangskreis (111) des modulierten Signals (RF) gekoppelt ist,

- eine erste (121) und eine zweite (122) Schalteinrichtung, die jeweils parallel mit einem symmetrischen Zweig (1201A, 1201B) der Y Verbindung verbunden sind,

wobei die Kopplung zwischen dem Eingangskreis (110) des zu modulierenden Signals (OL) und dem Eingangszweig (1200) der Leitung mit einem Spalt einerseits und zwischen dem Ausgangskreis (111) des modulierten Signals (RF) und der Leitung mit einem Spalt in der Form einer Schleife (1202) andererseits durch die Bezugsspannungsebene (1203) der Leitung mit einem Spalt (LF) gebildet ist, die ferner die Bezugsspannungsebene der Bandleitungen bildet, die jeweils den genannten Eingangskreis (110) des zu modulierenden Signals und den genannten Ausgangskreis (111) des modulierten Signals bilden, wobei der Eingangszweig (1200) der Leitung mit einem Spalt, die Y Verbindung (1201), die mittlere, leitende Zone (1204), die zwischen den symmetrischen Zweigen (1201A, 1201B) der Y Verbindung und der Leitung mit einem Spalt in der Form einer Schleife (1202) enthalten ist, und die Bandleitung, die den Ausgangskreis (111) des modulierten Signals bildet, zur selben Symmetrieachse, die die Symmetrieachse des Modulationskreises (120) bildet, die Symmetrielängsachse (Δ) der Bandleitung nehmen, die den genannten Ausgangskreis (111) des modulierten Signals bildet,

wobei der Modulator ferner umfaßt

b) Einrichtungen (2) mit getrennter Steuerung für die erste (121) und zweite (122) Schalteinrichtung, die der genannten ersten und zweiten Schalteinrichtung ein unabhängiges Schaltsteuersignal liefern, und die gebildet sind von

. einer Unterteilung (12040) der mittleren, leitenden Zone (1204) in zwei benachbarte, leitende Zonen (12041, 12042), wobei die genannte Unterteilung (12040) einen offenen Stromkreis für das Schaltsteuersignal (SCC) bildet, das der genannten ersten und zweiten Schalteinrichtung (121, 122) zugeführt wird, und einen Kurzschluß für das zu modulierende (OL) oder modulierte (RF) Mikrowellensignal,

. einem ersten (21) und einem zweiten (22) getrennten Steuerkreis, der genannten ersten und zweiten Schalteinrichtung (121, 122), die mit der einen bzw. der anderen benachbarten, leitenden Zone (12041, 12042) verbunden sind und ein Schaltsteuersignal (SCC) ausgehend von demselben Modulationssignal (SCM) liefern,

**dadurch gekennzeichnet,** daß die Unterteilung von einem mittleren Spalt (FC) gebildet ist, der symmetrisch in bezug auf die Symmetrieachse (Δ) des genannten Modulationskreises ist, eine Mehrzahl von Kondensatoren (Ci) gleichförmig entlang des Spalts verteilt ist und die Kurzschlußverbindung der zwei Ränder des genannten Spaltes bei der Frequenz des zu modulierenden oder modulierten Signals sicherstellt.

2. Modulator nach Anspruch 1, **dadurch gekennzeichnet,** daß die genannte erste und zweite Schalteinrichtung (121, 122) jeweils von einer Diode gebildet ist.

3. Modulator nach Anspruch 2, **dadurch gekennzeichnet,** daß jede Diode, die die erste (121) und die zweite (122) Schalteinrichtung bildet, an jedem Zweig (1201A, 1201B) der Y Verbindung zwischen der Bezugsspannungsebene und einer der benachbarten, leitenden Zonen angebracht ist, wobei die zwei Dioden auf der Leitung mit einem Spalt gegenpolig angebracht sind, der von den zwei symmetrischen Zweigen (1201A, 1201B) der Y Verbindung gebildet ist.

4. Modulator nach Anspruch 3, **dadurch gekennzeichnet,** daß das Schaltsteuersignal (SCC) von einem Wechselsignal gebildet ist, dessen Wechsel aufeinanderfolgend positiv und negativ (+V, -V) in bezug auf die Bezugsspannung des Modulators sind.

5. Modulator nach Anspruch 2, **dadurch gekennzeichnet,** daß jede Diode (121, 122) die die erste und die zweite Schalteinrichtung bilden, an jedem Zweig (1201A, 1201B) der Y Verbindung zwischen der Bezugsspannungsebene (1203) und einer der leitenden, benachbarten Zonen (12041, 12042) angebracht ist, wobei die zwei Dioden auf der Leitung mit einem Spalt parallel angebracht sind, die von den zwei symmetrischen Zweigen (1021A, 1201B) der Verbindung Y gebildet ist.

6. Modulator nach Anspruch 5, **dadurch gekennzeichnet,** daß das Phasenmodulationssteuersignal (SCM) von einem Wechselsignal gebildet ist, wobei die Schaltsteuersignale (SCC) der einen und der anderen Diode komplementär (SCM, $\overline{SCM}$) sind.

7. Modulator nach einem der Ansprüche 1 bis 6, **dadurch gekennzeichnet,** daß der genannte mittlere Spalt (FC) eine Breite von $1 \leqq \lambda/20$ aufweist, wo $\lambda$ die Wellenlänge des zu modulierenden Signals (OL) oder des modulierten Signals (RF) darstellt.

8. Zweiphasiger Gegentakt-Modulator für ein elektromagnetisches Mikowellensignal, umfassend:
a) eine zweiseitige, gedruckte Schaltung (1) umfassend:
eine erste Seite (11), die einen Eingangskreis (110) des zu modulierenden Signals (OL) und einen Ausgangskreis (111) des modulierten Signals (RF) umfaßt, wobei der genannte Eingangskreis (110) und der genannte Ausgangskreis (111) jeweils durch einen Bandleiter gebildet sind,
eine zweite Seite (12), die einen Phasenmodulationskreis (120) umfaßt, wobei der Phasenmodulationskreis gebildet ist durch:
- eine Leitung mit einem Spalt (LF), die einen Eingangszweig (1200) für das zu modulierende, elektrische Signal (OL), der mit dem genannten Eingangskreis (110) des zu modulierenden Signals gekoppelt ist, eine Y Verbindung (1201), die den genannten Eingangszweig verlängert und zwei symmetrische Zweige (1201A, 1201B) umfaßt, eine Leitung mit einem Spalt in der Form einer Schleife (1202), die die genannten symmetrischen Zweige verbindet, wobei die genannte Leitung mit einem Spalt in der Form einer Schleife (1202) mit dem genannten Ausgangskreis (111) des modulierten Signals (RF) gekoppelt ist,
- eine erste (121) und eine zweite (122) Schaltein-richtung, die jeweils parallel mit einem symmetrischen Zweig (1201A, 1201B) der Y Verbindung verbunden sind,
wobei die Kopplung zwischen dem Eingangskreis (110) des zu modulierenden Signals (OL) und dem Eingangszweig (1200) der Leitung mit einem Spalt einerseits und zwischen dem Ausgangskreis (111) des modulierten Signals (RF) und der Leitung mit einem Spalt in der Form einer Schleife (1202) andererseits durch die Bezugsspannungsebene (1203) der Leitung mit einem Spalt (LF) gebildet ist, die ferner die Bezugsspannungsebene der Bandleitungen bildet, die jeweils den genannten Eingangskreis (110) des zu modulierenden Signals und den genannten Ausgangskreis (111) des modulierten Signals bilden, wobei der Eingangszweig (1200) der Leitung mit Spalt, die Y Verbindung (1201), die mittlere, leitende Zone (1204), die zwischen den symmetrischen Zweigen (1201A, 1201B) der Y Verbindung und der Leitung mit einem Spalt in der Form einer Schleife (1202) enthalten ist, und die Bandleitung, die den Ausgangskreis (111) des modulierten Signals bildet, zur selben Symmetrieachse, die die Symmetrieachse des Modulationskreises (129) bildet, die Symmetrielängsachse (Δ) der Bandleitung nehmen, die den genannten Ausgangskreis (111) des modulierten Signals bildet.
wobei der Modulator ferner umfaßt
b) Einrichtungen (2) mit getrennter Steuerung für die erste (121) und zweite (122) Schalteinrichtung, die der genannten ersten und zweiten Schalteinrichtung ein unabhängiges Schaltsteuersignal liefern, und die gebildet sind von
. einer Unterteilung (12040) der mittleren, leitenden Zone (1204) in zwei benachbarte, leitende Zonen (12041, 12042), wobei die genannte Unterteilung (12040) einen offenen Stromkreis für das Schaltsteuer-signal (SCC) bildet, das der genannten ersten und zweiten Schalteinrichtung (121, 122) zugeführt wird, und einen Kurzschluß für das zu modulierende (OL) oder modulierte (RF) Mikrowellensignal,

. einem ersten (21) und einem zweiten (22) Kreis getrennter Steuerung der genannten ersten und zweiten Schalteinrichtung (121, 122), die mit der einen bzw. der anderen benachbarten, leitenden Zone (12041, 12042) verbunden sind und ein Schaltsteuersignal (SCC) ausgehend von demselben Modulationssignal (SCM) liefern,

**dadurch gekennzeichnet,** daß die Unterteilung (12040) gebildet ist von:

einer ersten, elektrisch leitenden Zone (12041P), die gegenüber der mittleren, leitenden Zone (1204) eine Halbinsel bildet und bestimmt ist, einen der Anschlüsse einer der Schalteinrichtungen zu erhalten, wobei ein isolierendes Intervall in Bandform einen Teil des Umfangs der Halbinsel von der mittleren, leitenden Zone trennt,

einer zweiten, elektrisch leitenden Zone (12042), die gegenüber der mittleren, leitenden Zone eine Insel bildet und bestimmt ist, einen der Anschlüsse der anderen Schalteinrichtung zu erhalten, wobei ein isolierendes Intervall in Bandform den gesamten Umfang der Insel von der mittleren, leitenden Zone trennt,

wobei die erste und zweite elektrisch leitende Zone, die die Halbinsel (12041P) bzw. die Insel (12042) gegenüber der mittleren, leitenden Zone bilden, im wesentlichen symmetrisch in bezug auf die Symmetrieachse (Δ) des Modulatorkreises sind, wobei die genannte, elektrisch leitende Zone (12042), die die Insel bildet, elektrisch mit der leitenden, mittleren Zone (1204) über wenigstens einen Kondensator (C) verbunden ist, der bei der Frequenz des zu modulierenden oder des modulierten Signals einen Kurzschluß bildet.

9. Modulator nach Anspruch 8, **dadurch gekennnzeichnet,** daß die größte Abmessung der Begrenzung der elektrisch leitenden Zonen (12041P, 12042), die eine Halbinsel oder Insel bilden, kleiner oder gleich λ/10 ist, wo λ die Wellenlänge des zu modulierenden Signals oder des modulierten Signals darstellt.

10. Modulator gemäß Anspruch 9, **dadurch gekennzeichnet,** daß die elektrischleitende Zone, die eine Halbinsel (12041P) bildet, mit der genannten elektrischleitenden, mittleren Zone (1204) über wenigstens einen Steg (12043P) verbunden ist, wobei das Intervall, das die elektrischleitende Zone, die die Insel bildet, von der elektrischleitenden, mittleren Zone trennt mit mindestens einem abgeschnittenen Steg (12044) ausgerüstet ist, in dem das Intervall enger als längs des restlichen Umfangs der Insel ist, wobei die abgeschnittenen Stege und die Stege symmetrisch in bezug auf die Symmetrieachse Δ des Modulatorkreises angeordnet sind.

11. Modulator gemäß einem der Ansprüche 8 bis 10, **dadurch gekennzeichnet,** daß die genannte erste und zweite Schalteinrichtung (121, 122) jeweils von einer Diode gebildet sind.

12. Gegentakt-Modulator für Mikrowellensignale, **dadurch gekennzeichnet,** daß der genannte Modulator einen Hybrid-Kopplungskreis (3), einen ersten und einen zweiten, zweiphasigen Gegentakt-Modulator (4, 5) gemäß einem der vorhergehenden Ansprüche und einen Leistungssummierkreis (6) vom Typ Wilkinson umfaßt, der Hybrid-Kopplungskreis (3) an einem seiner Eingänge das zu modulierende Signal (L) erhält, während der symmetrische Eingang des Hybrid-Kopplungskreises (3) mit einer Impedanz belastet ist, die gleich einer charakteristischen Impedanz (ZC) ist, und der erste und zweite symmetrische Ausgang dieses Kopplungskreises (3) jeweils mit dem Eingangszweig der Leitung mit einem Spalt (1200) des ersten und des zweiten, zweiphasigen Modulators (4, 5) gekoppelt ist, deren Leitungen der Ausgangskreise (111) mit dem Eingangsanschluß des Leistungssummierers vom Typ Wilkinson (6) verbunden sind.

**Claims**

1. Balanced two-phase modulator for a UHF electromagnetic signal including:

   a) a two-sided printed circuit (1) comprising:

   . a first face (11) comprising an input circuit (110) for the signal to be modulated (OL) and an output circuit (111) for the modulated signal (RF), the said input (110) and output (111) circuits each being formed by a ribbon conductor,

   . a second face (12) comprising a phase modulation circuit (120), the said phase modulation circuit being formed by:

   - a slotted line (LF) comprising an input arm (1200) for the electrical signal to be modulated (OL) coupled to the said input circuit (110) for the signal to be modulated, a Y junction (1201) extending the said input arm and including two symmetrical arms (1201A, 1201B), a slotted line in loop form (1202) connecting the said symmetrical arms, the said slotted line in loop form (1202) being coupled to the said output circuit (111) for the modulated signal (RF),
- first (121) and second (122) switching means connected respectively in parallel to symmetrical arms (1201A, 1201B) of the Y junction,
the coupling between the input circuit (110) for the signal to be modulated (OL) and the input arm (1200) of the slotted line on the one hand, and between the output circuit (111) for the modulated signal (RF) and the slotted line in loop form (1202) on the other hand, being formed by the reference voltage plane (1203) of the slotted line (LF), which also constitutes the reference voltage plane for the ribbon conductors forming respectively the said input circuit (110) for the signal to be modulated and output circuit (111) for the modulated signal, the input arm (1200) of the slotted line, the Y junction (1201), the central conducting region (1204) contained between the symmetrical arms (1201A, 1201B) of the Y junction and the slotted line in loop form (1202), and the ribbon conductor constituting an output circuit (111) for the modulated signal allowing for the same symmetry axis, constituting a symmetry axis for the modulation circuit (120), the longitudinal symmetry axis ($\Delta$) of the ribbon conductor constituting the said output circuit (111) for the modulated signal,
the said modulator also including
b) control means (2) separate from the said first (121) and second (122) switching means, delivering an independent switching control signal to the said first and second switching means, and consisting of
. a partition (12040) dividing the central conducting region (1204) into two adjacent conducting regions (12041, 12042), the said partition (12040) constituting an open circuit for the switching control signal (SCC) delivered to the said first and second switching means (121, 122) and a short-circuit for the UHF signal which is to be modulated (OL) or which has been modulated (RF),
. first (21) and second (22) control circuits separate from the said first and second switching means (121, 122), respectively connected to each of the adjacent conducting regions (12041, 12042) and delivering a switching control signal (SCC) from one and the same modulation signal (SCM),
characterised in that, the said partition being formed by a central slot (FC) symmetrical with respect to the symmetry axis ($\Delta$) of the said modulation circuit, a plurality of capacitors (Ci) are evenly distributed along the slot and provide the short-circuit connection of the two edges of the said slot at the frequency of the signal which is to be modulated or which has been modulated.

2. Modulator according to Claim 1, characterised in that the said first and second switching means (121, 122) each consist of a diode.

3. Modulator according to Claim 2, characterised in that each diode constituting the first (121) and second (122) switching means is mounted on each of the arms (1201A, 1201B) of the Y junction between the reference voltage plane and one of the adjacent conducting regions, the two diodes being on the slotted line formed by the two symmetrical arms (1201A, 1201B) of the Y junction mounted in antiparallel arrangement.

4. Modulator according to Claim 3, characterised in that the switching control signal (SCC) is formed by an alternating signal, the alternations of which are successively positive and negative (+V, -V) with respect to the reference voltage of the modulator.

5. Modulator according to Claim 2, characterised in that each diode (121, 122), constituting the first and second switching means, is mounted on each of the arms (1201A, 1201B) of the Y junction between the reference voltage plane (1203) and one of the adjacent conducting regions (12041, 12042), the two diodes being on the slotted line formed by the two symmetrical arms (1201A, 1201B) of the Y junction mounted in parallel.

6. Modulator according to Claim 5, characterised in that the phase modulation control signal (SCM) is formed by an alternating signal, the switching control signals (SCC) for each of the diodes being complementary (SCM, $\overline{SCM}$).

7. Modulator according to one of Claims 1 to 6, characterised in that the said central slot (FC) has a width

$$l \leq \frac{\lambda}{20}$$

where $\lambda$ represents the wavelength of the signal which is to be modulated (OL) or which has been modulated (RF).

8. Balanced two-phase modulator for a UHF electromagnetic signal comprising:

a) a two-sided printed circuit (1) comprising:

. a first face (11) comprising an input circuit (110) for the signal to be modulated (OL) and an output circuit (111) for the modulated signal (RF), the said input (110) and output (111) circuits each being formed by a ribbon conductor,

. a second face (12) comprising a phase modulation circuit (120), the said phase modulation circuit being formed by:

- a slotted line (LF) comprising an input arm (1200) for the electrical signal to be modulated (OL) coupled to the said input circuit (110) for the signal to be modulated, a Y junction (1201) extending the said input arm and including two symmetrical arms (1201A, 1201B), a slotted line in loop form (1202) connecting the said symmetrical arms, the said slotted line in loop form (1202) being coupled to the said output circuit (111) for the modulated signal (RF),

- first (121) and second (122) switching means connected respectively in parallel to a symmetrical arm (1201A, 1201B) of the Y junction,

the coupling between the input circuit (110) for the signal to be modulated (OL) and the input arm (1200) of the slotted line on the one hand, and between the output circuit (111) for the modulated signal (RF) and the slotted line in loop form (1202) on the other hand, being formed by the reference voltage plane (1203) of the slotted line (LF), which also constitutes the reference voltage plane for the ribbon conductors forming respectively the said input circuit (110) for the signal to be modulated and output circuit (111) for the modulated signal, the input arm (1200) of the slotted line, the Y junction (1201), the central conducting region (1204) contained between the symmetrical arms (1201A, 1201B) of the Y junction and the slotted line in loop form (1202), and the ribbon conductor constituting an output circuit (111) for the modulated signal allowing for the same symmetry axis, constituting a symmetry axis for the modulation circuit (120), the longitudinal symmetry axis (Δ) of the ribbon conductor constituting the said output circuit (111) for the modulated signal,

the said modulator also including

b) control means (2) separate from the said first (121) and second (122) switching means, delivering an independent switching control signal to the said first and second switching means, and consisting of

. a partition (12040) dividing the central conducting region (1204) into two adjacent conducting regions (12041, 12042), the said partition (12040) constituting an open circuit for the switching control signal (SCC) delivered to the said first and second switching means (121, 122) and a short-circuit for the UHF signal which is to be modulated (OL) or which has been modulated (RF),

. first (21) and second (22) control circuits separate from the said first and second switching means (121, 122), respectively connected to each of the adjacent conducting regions (12041, 12042) and delivering a switching control signal (SCC) from one and the same modulation signal (SCM),

characterised in that the said partition (12040) is formed by:

. a first electrically conducting region (12041P) forming a peninsula vis-a-vis the conducting central region (1204) and intended to receive one of the terminals of one of the switching means, an insulating interval in the form of a strip separating part of the circumference of the peninsula from the conducting central region,

. a second electrically conducting region (12042) forming an island vis-a-vis the conducting central region and intended to receive one of the terminals of the other switching means, an insulating interval in the form of a strip separating the entire circumference of the island from the conducting central region, the first and second electrically conducting regions, forming respectively a peninsula (12041P) and island (12042) vis-a-vis the conducting central region, being substantially symmetrical with respect to the symmetry axis (Δ) of the modulator circuit, the said electrically conducting region (12042) forming an island being connected electrically to the conducting central region (1204) by at least one capacitor (C) forming a short-circuit at the frequency of the signal to be modulated or of the modulated signal.

9. Modulator according to Claim 8, characterised in that the largest dimension defining the electrically conducting zones (12041P, 12042) forming a peninsula or island is equal to or less than $\frac{\lambda}{10}$ where $\lambda$ represents the wavelength of the signal to be modulated or of the modulated signal.

10. Modulator according to Claim 9, characterised in that the said electrically conducting region forming a peninsula (12041P) is connected to the said central electrically conducting region (1204) by at least one isthmus (12403P), the interval separating the electrically conducting region forming an island from the central electrically conducting region being provided with at least one truncated isthmus (12044) in which the interval is narrower than along the remainder of the circumference of the island, the truncated isthmuses and the isthmuses being disposed symmetrically with respect to the symmetry axis ($\Delta$) of the modulator circuit.

11. Modulator according to one of Claims 8 to 10, characterised in that the said first and second switching means (121, 122) each consist of a diode.

12. Balanced modulator for a UHF signal, characterised in that the said modulator includes a hybrid coupling circuit (3), first and second balanced two-phase modulators (4, 5) according to one of the preceding claims and a power adding circuit (6) of the Wilkinson type, the hybrid coupling circuit (3) receiving the signal to be modulated (OL) at one of its inputs, whilst the symmetrical input of the hybrid coupler (3) is charged through an impedance equal to the characteristic impedance (ZC), and the first and second symmetrical outputs of this coupler (3) are coupled respectively to the input arm of the slotted line (1200) of the first and second two-phase modulators (4, 5), the output circuit conductors (111) of which are connected to the input port of the Wilkinson-type power adder (6).

FIG_1a

FIG_1b

FIG_1c

FIG.2a

FIG.2b

**FIG. 3a**

**FIG. 3b**

FIG_4a

FIG_4b

FIG_4c